# EUROPEAN PATENT SPECIFICATION

(11) **EP 1 475 909 B1**
(45) Date of publication and mention of the grant of the patent: **28.09.2011**
(21) Application number: 03010418.6
(22) Date of filing: 08.05.2003
(51) Int. Cl.: H04H 20/55

(54) **Background tuner of a radio broadcast receiver to receive traffic and travel information (TTI) and to check alternative frequencies**
Hintergrundtuner eines Rundfunkempfängers zum Empfangen von Verkehrs- und Reise-Information und zum Untersuchen von alternativen Frequenzen
Syntoniseur d'arrière-plan dans un récepteur de radio pour recevoir des renseignements de trafic et voyages et pour vérifier des fréquences alternatives

(43) Date of publication of application: 10.11.2004
(73) Proprietor: Harman Becker Automotive Systems GmbH, 76303 Karlsbad (DE)
(72) Inventor: Benz, Christoph, 77797 Ohlsbach (DE); Körner, Andreas, 76337 Waldbronn (DE); Gierl, Stefan, 76133 Karlsruhe (DE)
(74) Representative: Grünecker, Kinkeldey, Stockmair & Schwanhäusser Anwaltssozietät

(56) References cited:
- EP-A- 0 977 386
- EP-A- 1 303 065
- DE-A- 19 830 608
- US-A- 5 553 313

## Description

### Field of the invention

The present invention relates to a method for receiving digital data in a radio broadcast receiver including a main tuner and a background tuner. Further, the present invention relates to a radio broadcast receiver for receiving digital information contained in radio broadcast channel signals.

### Background of the invention

Worsening traffic congestions on streets for automobile vehicles have generated demands on accurate and timely information on traffic conditions. Broadcasters cannot respond simply by increasing the number of on-air announcements in their traditional delivery modes. This would be unacceptable to the public, many of whom express concerns that such announcements are distrustful, repetitive and irritating unless - of course - the information is relevant to them. The transmission of traffic and travel information (TTI) via data broadcast nodes potentially solve this problem because the TTI data can be transmitted inaudibly and furthermore it can be filtered at the receiver to ensure that the end-users only obtain data which is relevant to their journey.

Multiple delivery methods of TTI services have emerged in the meantime. For example, digital audio broadcast (DAB), digital video broadcasting-terrestrial (DVBT), the global system for mobile communications (GSM), the universal mobile telecommunication system (UMTS) and the well known radio data system (RDS) are examples for broadcast delivery methods of traffic and travel information (TTI). Also approaches to deliver this information via the Internet have been proposed.

Since RDS has widely deployed by the radio broadcasters in Europe and elsewhere, car manufactures have integrated the car radio receiver with multi-functional displays in the dashboard. Often, these integrated systems further include modules such as telematic devices or navigation system.

RDS uses a technique of adding data to a sub-carrier on an existing stereo transmission in such a way that the data is carried inaudibly. RDS is designed with a wide range of features to support program-related aspects and to allow non-program-related data services to also be added, if capacity exists

The most known RDS features are those seen on a typical RDS radio broadcast receiver. Modern car receivers usually support the following services. The service Alternative Frequencies (AF) is intended to give information on the frequencies at which various transmitters broadcast the same radio program in the same or adjacent reception areas, to enable radio broadcast receivers equipped with a memory to store a list of alternative frequencies to reduce the time for switching to another frequency or transmitter. The program service (PS) name feature is designed to provide information for an RDS receiver to display the name of the radio broadcast program service instead of, for example, the tuning frequency in the display.

Other important features are the traffic announcements (TA) and the traffic program (TP) service informing a receiver that the transmission being received carries traffic announcements or not. Services further supported by RDS are program type (PT), radio text (RT), clock type and date (CT), decoder identification (DI), dynamic PTY indicator (PTYI), enhanced other networks information (EON), music speech switch (MS), open data applications (ODA) and program item number (PIN).

Another important service provided by the RDS specification is the traffic message channel (TMC). The objective of RDS-TMC is to broadcast digital traffic and travel information (TTI) messages as data on FM transmission using RDS. This allows delivery of accurate, timely and relevant information without the need to interrupt the radio program.

A modern radio broadcast receiver may generally comprise a main tuner and a background tuner. The main tuner is usually responsible for receiving the radio broadcast program at a predetermined frequency selected by the listener and for providing the received audio signal to an outputting unit, such as a speaker. Further, the main tuner Is used to receive RDS data corresponding to the radio broadcast program to which it is tuned, main task of the background tuner is to scan the frequency band for alternative frequencies for receiving the same radio broadcast program to which the main tuner is tuned. Commonly, those alternative frequencies are provided within an RDS data stream (Alternative Frequencies feature) which is analysed by the background tuner to obtain information on the alternative frequencies.

The main tuner may be used to receive data block including traffic and travel information (TTI), for example RDS-TMC data. Another possibility is to receive such data blocks at the background tuner. In both solutions, the main tuner and the background tuner respectively have to be tuned to a fixed frequency.

In order to provide accurate, timely and relevant information, it is important to receive all data blocks broadcasted from a single radio broadcast channel signal. However, it may be undesirable to receive only the data blocks of the radio broadcast channel the main tuner and/or the background tuner is currently tuned to. For instance, it may be desirable to constantly receive data blocks from a predetermined radio broadcast program while the program selected by the user and to which the main tuner is tuned is frequently changing.

Hence, there arises the problem of steadily receiving the TMC data on the predetermined radio broadcast program using the background tuner while not impairing its diversity functionality, i.e., scanning the frequency band for alternative frequencies of the selected radio broadcast program of the main tuner, receiving RDS information for the latter program, etc.

US 5,553,313 relates to an apparatus for the detection of information expected to be present in defined data blocks of an RDS data flow in the form of a predetermined number of groups which periodically follow one another with a radio receiver tuned in one after the other to a number of senders to be tested and whose RDS decoder is synchronized with the RDS data flow of the respective tuned in sender. Th system disclosed in US 5,553,313 uses of a counter that indicates the repetition cycle of RDS data that is is increased with the RDS data cycle of 1187.5Hz. Upon reaching the counter-value the background tuner switches from previous receiving frequency to the receiving frequency of the channel on which the desired information, such as traffic information.

EP 0 977 386 A1 relates to a digital signal receiving device which can receive programs over a plurality of networks in a multiplex broadcast system, and in particular an FM multiplex signal receiving device which receives the program data transmitted by FM multiplex broadcast system. EP 0 977 386 A1 aims to provide a digital signal receiving device, which can be used in an operation of asynchronously receiving and reconfiguring packet data received by switching a plurality of networks in a multiplex broadcast, and particularly can prevent output of information sent over a last selected network after switching of the network.

It is therefore an object of the present invention to overcome the disadvantages of prior radio receivers.

It is a further object of the present invention to provide a method for receiving digital data In a radio broadcast system and to provide a radio broadcast receiver, which allow complete reception of data blocks such as traffic and travel information (TTI) by the background tuner, without impairing its diversity functionality.

### Summary of the invention

The above problem is solved by the subject-matter of independent claim 1 and by the subject matter of claim 16.

The present invention provides a method for receiving digital data in a radio broadcast receiver, which tunes the main tuner to a first receiving frequency to receive a first broadcast channel signal, tunes the background tuner to a second receiving frequency to receive a second broadcast channel signal, said second broadcast channel signal comprising digital information in data blocks, receives a first data block in the second broadcast channel signal at the background tuner, estimates the time for transmission of the second data block in the second broadcast channel signal, tunes the background tuner to a third receiving frequency upon completing reception of the first data block and tunes the background tuner to said second receiving frequency at the estimated time of transmission of the second data block, a statistic on the deviation of the time interval between data blocks on the second broadcast channel is maintained and the time interval is determined based on the statistic.

Hence, the background tuner is not steadily tuned to a radio broadcast channel, which has been selected to provide the necessary traffic and travel information, but is only tuned to this channel during short time intervals, in which the data blocks are expected to be received. Therefore, it is possible to maintain the background tuner's diversity functionality, i.e. scanning the frequency band for alternative frequencies for the optimal reception of the radio broadcast program to which the main tuner is tuned, while ensuring the safe reception of data blocks in an alternative, second radio channel signal.

The timing at which the data blocks should be received on the TTI providing radio broadcast channel (second radio broadcast channel) may, for example, be determined by measuring the mean time interval between successive TMC data block in the RDS data stream.

In case, the switching to the second radio broadcast channel signal to receive a second data block should happen too late and thesecond data block cannot be received, it is advantageous to tune the background tuner to the at least third radio broadcast channel in case a predetermined time interval has elapsed without receiving a data block contained in the second radio broadcast channel signal. The predetermined time interval is the time interval, after which the beginning of a data block in the second radio broadcast channel signal should have been detected when trying to receive the second data block in the second radio broadcast channel signal.

It is further possible that the radio broadcast channel signals received at the first and the third receiving frequency provide the same radio broadcast program.

The method may further include a scanning operation in which the background tuner is tuned to a third receiving frequency at certain points in time. The third receiving frequency (or a plurality of third receiving frequencies as the case may be) can be used to determine the quality of alternative receiving frequencies for the first receiving frequency (diversity functionality). The background tuner may be tuned to the third receiving frequencies in the time span between the end of the reception of the first data block contained in the second radio broadcast channel signal and the beginning of the estimated point in time of the transmission of the second data block.

In order to read digital information, for example, in the form of RDS information from the third radio broadcast channel signal, the method comprises the step of receiving digital information contained in the third radio broadcast channel signal at the background tuner to determine alternative reception frequencies of the radio broadcast program. Moreover, the digital information contained in the second and/or third radio broadcast channel signal can be advantageously reproduced in an audio and/or visible format to the user

For the usage of traffic and travel information (TTI), it may be desirable to supply the digital information in the second radio broadcast channel signal to a navigation system to enable the navigation system to select the travel route based on the received TTI information (dynamic navigation)

It may further be desirable for the navigation system to select the second receiving frequency based on travel route information as the navigation system is informed about the planned travelling route.

To be responsive to changes in the reception quality of radio broadcast signals, e.g. due to fading or interference, a statistic on the deviation of the time interval between data blocks on the second broadcast channel signal is maintained and the time interval is determined based on the statistic.

It may be desirable if the statistic is updated each time the background tuner changes the tuning from the at least third receiving frequency to the second receiving frequency. The statistic maybe further used to vary the predetermined time interval based on the statistic.

Digital information contained in the second broadcast channel signal are, for example, traffic and travel information (TTI), such as traffic message channel (TMC) information. The digital information contained in the third radio broadcast channel signal are, for example, traffic and travel information (TTI) for radio data system (RDS) information.

Further, the present invention provides a radio broadcast receiver for receiving digital information contained in radio broadcast channel signals. In order to solve the above stated object, the radio broadcast receiver comprises a main tuner for receiving a first broadcast channel signal at a first receiving frequency, a background tuner for receiving a second broadcast channel signal at a second receiving frequency and for receiving a third broadcast channel signal at a third receiving frequency, said second radio broadcast signal comprising digital data, said digital data being transmitted as discrete data blocks, timing means for estimating the time of transmission of the second data block in said second radio broadcast channel signal, wherein the background tuner comprises switching means for switching the background tuner to the second receiving frequency for receiving the data block, for switching the background tuner to at least one third receiving frequency after completion of the reception of the data block and for switching the background tuner back to said second receiving frequency for receiving the second data block at the time estimated by the timing means.

Advantageously, the switching means are adapted to switch the background tuner to the at least third receiving frequency in case a predetermined time interval has elapsed without receiving a data block in the second radio broadcast channel signal.

Moreover, it is possible that the radio broadcast channel signals received at the first and the at least third receiving frequency provide the same radio broadcast program

In order to display the digital information contained in the second and/or third radio broadcast channel signal, it is of advantage if the radio broadcast receiver comprises a display.

To output the digital information contained in the second and/or third radio broadcast channel signal, the radio broadcast receiver may also comprise a speaker.

For implementing the RDS typical service of scanning for alternative receiving frequencies for a radio broadcast program, the background tuner comprises frequency selection means for scanning the frequency band for the receiving frequency providing the best reception quality of the radio broadcast program. The background tuner scans the frequency band in a time span between the end of the reception of the data block contained in the second radio broadcast channel signal and the estimated point in time of transmission of the second data block.

The digital information contained in the second radio broadcast channel signal may further be supplied to a navigation system which is connected to the radio broadcast receiver.

The background tuner may be adapted to select the second receiving frequency based on travel route information provided by the navigation system.

The radio broadcast receiver may further comprise reception quality measurement means for measuring the reception quality of the second and/or third broadcast channel signal to be responsive to fluctuations in the reception quality of radio broadcast channel signals, for example due to fading and interference.

These measurement results can be used in the timing means to determine the time interval and the predetermined time interval based on the measured reception quality.

The inventive radio broadcast receiver can be used in a in-vehicle receiver.

### Brief description of the figures

In the following, the present invention is described in more detail and referenced to the attached figures and drawings showing preferred embodiments of the invention. Similar are corresponding details in the figures were marked with the same reference numerals.
- **Figure 1**: shows structural details of a radio broadcast receiver according to the present invention,
- **Figure 2**: shows the format of type 8A groups used for transmitting RDS-TMC information,
- **Figure 3**: shows the switching between a second radio broadcast channel signal carrying RDS-TMC data and a third radio broadcast channel containing an RDS data stream, and
- **Figure 4**: shows, the switching between the second radio broadcast channel signal and the third radio broadcast channel signal in case a RDS-TMC data block on the second radio broadcast channel has been missed.

### Detailed description of the invention

Modern broadcasting systems often transmit digital information in combination with broadcasting a program. For example, the RDS data stream may transmit embedded TMC data . The time interval between two successive TMC data blocks is thereby not constant but varies typically between 900ms and 1400ms. This corresponds to a time interval of roughly 8 to 12 RDS data blocks.

Though, the present invention will be described in reference to the RDS standard for radio receivers and to TTI information transmitted in Traffic Message Channel (TMC) format data, the method for receiving digital information described herein is also applicable to other systems broadcasting digital information in combination with broadcasting a signal such as DAB, GSM or UMTS services. Due to the close relationship between the European RDS standard and the US radio broadcast data system (RBDS) standard, the present invention may be also implemented in an RBDS environment. Further it is noted that this principles disclosed herein are also applicable to dynamic and static RDS.

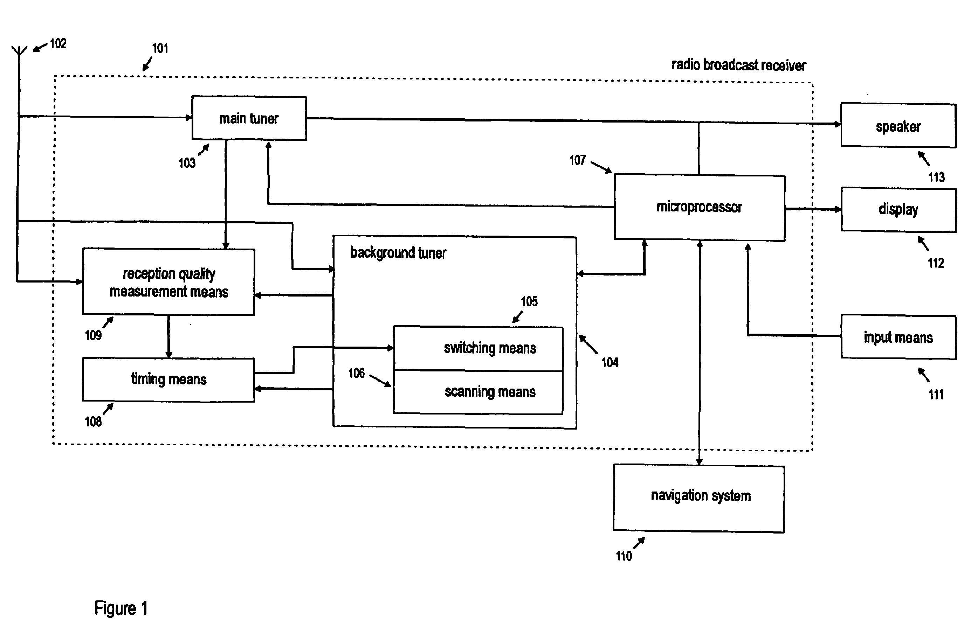

For the TMC performance of a radio broadcast receiver 101 (see Fig. 1), it is important that all TMC data blocks are received and decoded successfully. Especially during TMC-data reception in a background tuner 104 which is commonly used in a diversity broadcasting system for optimising the reception of radio broadcast program in a radio broadcast receiver 101, conflicting requirements arise.

If the continuous reception of the TMC data stream is achieved by continuously receiving the associated program, the background tuner 104 is no longer able to scan the frequency band for determining the optimal frequency for receiving the radio broadcast channel selected by the user. If the background tuner is permanently scanning the frequency band for finding the receiving frequency providing the best possible reception characteristics for the user-selected radio broadcast program, TMC data can only be received sporadically.

In the present invention, the background tuner 104 is tuned to the radio broadcast channel that transmits TMC data. The timing means 108 estimates the time at which the successive data block will be transmitted. This procedure can also be considered as the initialisation of the background tuner 104 of the radio broadcast receiver 101. Depending on the duration of this initialisation phase, it is further possible to determine the timely deviation in between the successive TMC data blocks.

After finishing the initialisation procedure, the background tuner 104 can continue "normal" operation, i.e. to perform its diversity functionality in order to determine the best possible receiving frequency for the radio broadcast program which is received by the main tuner and output to the user. The radio broadcast channel program, output to the user, does not necessarily have to correspond to the radio broadcast channel signal providing traffic and travel information (TTI).

Fig. 1 shows structural details of a radio broadcast receiver 101 according to the present invention. The radio broadcast receiver 101 is connected to an antenna 102, a navigation system 110 and to a human-machine-interface comprising a input means 111, a display 112 and a speaker 113.

The input means 111 provides the possibility to input commands for selecting the desired radio broadcast channel to which the user wants to listen, programming the navigation system 110 and adjusting receiver settings, etc. of the radio broadcast receiver 101. The display 112 is used to display information, such as RDS data (program service name, program type, radio text, clock time and date, etc.). TTI information may also be displayed. The speaker 113 outputs the selected radio broadcast program. Further, it can also be considered to output RDS information in audio format to the user of the radio broadcast receiver 101.

The radio broadcast receiver 101 further comprises a main tuner 103 and a background tuner 104. It includes a microprocessor 107, timing means 108 and a reception quality measurement means 109.

The background tuner includes switching means 105 and scanning means 106. Further, the background tuner 104 may comprise frequency selection means - not shown in the Fig. 1 - which select the optimised receiving frequency of the radio broadcast channel signal providing the user-selected program.

The signals received by antenna 102 are inputted to the main tuner 103, the background tuner 104 and the reception quality measurement means 108. The main tuner 103 is connected to speaker 113 to output the radio broadcast program selected by the user. Further, main tuner 103 and background tuner 104 are connected to the reception quality measurement means 109, which measure the reception quality of the radio broadcast channel/s to which the main tuner 103 and/or background tuner 104 is/are tuned to.

The reception quality is provided to the timing means 108 in order that the timing means 108 may determine a switching time interval T and a predetermined time interval T_{back-off,} which will be described in more detail below The background tuner 104 is further connected to microprocessor 107 and to timing means 108.

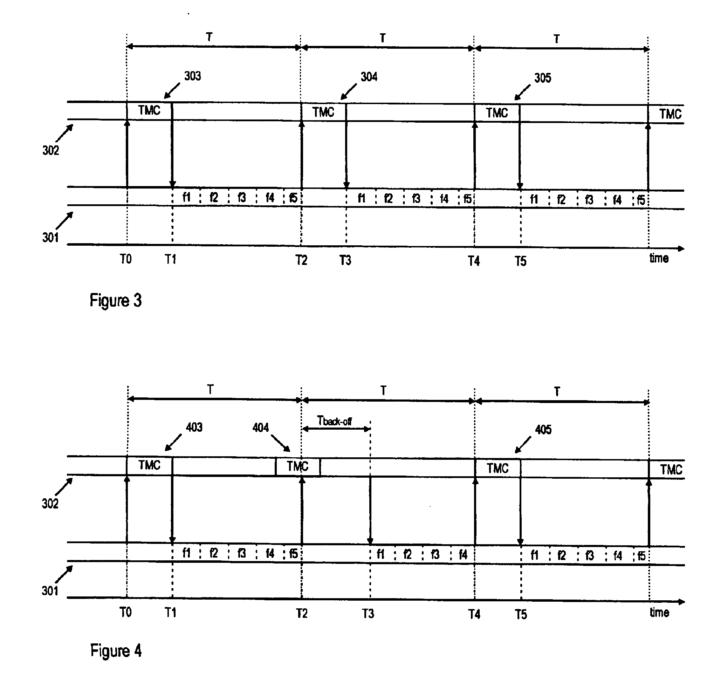

The microprocessor 107 communicates with the navigation system 110, i.e. is used for data exchange with it. For example, TTI information received by the background tuner 104 may be forwarded to the navigation system 110 or the navigation system 110 may request to tune the background tuner 104 to a new TTI-data delivering radio broadcast channel signal 302 (see Fig. 3).

The timing means 108 are connected to the switching means 105 to provide a trigger signal at which the switching means 108 change the tuning of background tuner 104 from the radio broadcast channel signal 301 receiving the user-selected radio broadcast program and a radio broadcast channel signal 302 which has been selected to provide traffic and travel (TTI) information.

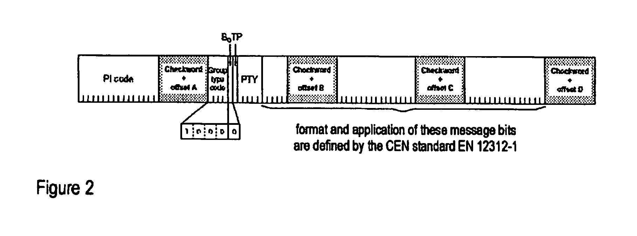

Fig. 2 shows the format of a type 8A group which provide traffic message channel TMC information in an RDS data stream. The figure illustrates an RDS data block of which different types exist to provide the RDS features. Different types of the RDS packets are concatenated to build the RDS data stream. TMC information are provided in the shown packet format and the RDS-TMC data block are delivered spaced by a time interval of approximately 900 ms up to 1400 ms. For more detailed information about packet types and the RDS standard it is referred to the respective documents defining the RDS standard and the employed protocols, which are available at the Comité Européen de Normalisation.

In reference with Fig. 3, the idea of the present invention is illustrated in the following. The radio broadcast receiver 101 according to the present invention provides the possibility to receive a traffic and travel information (TTI) carrying radio broadcast channel signal 302 in the background tuner 104 of the receiver 101 without impairing the diversity functionality of the background receiver 104.

The background tuner 104 in the radio broadcast receiver 101 is used to scan for alternative frequencies for best receiving the radio broadcast channel signal 301 providing the user-selected program. Hence, one of the main tasks of the background tuner 104 is to provide this RDS typical service.

However, the navigation system 110 or the user may wish to receive traffic and travel information (TTI) on an alternative radio broadcast channel signal providing this information. Especially in case in which the user selects different radio broadcast channel signals frequently, it is desirable that the radio broadcast receiver 101 is still receiving one single radio broadcast channel signal in order to provide accurate and timely traffic and travel information (TTI) to the user and/or to the attached navigation system 110.

During an initialisation phase, the background tuner 104 is tuned to a receiving frequency of the radio broadcast channel signal 302 and the timing means 108 are used to determine a time interval T between successive TMC data block 303, 304 and 305. Further, a statistic about the time deviation of the beginning of the TMC data blocks 303, 304 and 305 from the determined time interval T is generated and maintained in the radio broadcast receiver 101.

The operation of the radio broadcast receiver 101 can be summarized as follows: after initialising the background tuner 104 by receiving some number of TMC data blocks 303, 304 and 305 to determine the time interval T between successive TMC data blocks 303, 304 and 305 and, generating and maintaining the above-mentioned statistic, the background tuner 104 changes to "normal" operation. Under "normal" operation, the background tuner 104 is tuned to at least one receiving frequency of the radio broadcast channel signal 301 to scan the frequency band for alternative frequencies to receive the radio broadcast channel signal 301.The blocks in the radio broadcast signal 301 marked with f1, f2, f3, f4 and f5 indicate the diversity functionality of the radio broadcast receiver 101, i.e. the scanning of the alternative frequencies f1, f2, f3, f4, f5 for an optimised receiving frequency to receive the radio broadcast program. The radio broadcast channel signal to which the main tuner 103 is tuned and the radio broadcast channel signal 301 to which the background tuner 104 is temporarily tuned may provide the same radio broadcast program.

When the timing means 108 provide a trigger signal to the switching means 105 at T0 the background tuner 104 switches its tuning from radio broadcast channel signal 301 to radio broadcast channel signal 302 providing the digital TTI (in the present embodiment RDS-TMC) data. At time T0, a TMC data block 303 is expected to be received in the radio broadcast channel signal 302. After having received this data block 303, the background tuner 104 tunes back to the radio broadcast channel signal 301 providing the user-selected program at time T1 using switching means 105. In the remaining time period of time interval T between T1 and T2, the background tuner 104 may continue to scan the alternative reception frequencies f1, f2, f3, f4, f5 of the radio broadcast channel signal 301. To obtain the RDS information at which alternative frequencies f1, f2, f3, f4, f5 the radio broadcast channel signal 301 signal is broadcasted, the background tuner 104 can read the RDS-data stream comprised in the radio broadcast channel signal 301 to obtain the necessary information. Alternatively the main tuner 103 may read the RDS-data stream comprised in the radio broadcast channel signal to which it is tuned to obtain the alternative frequencies f1, f2, f3, f4, f5 of the radio broadcast program. After obtaining the alternative frequencies f1, f2, f3, f4, f5 the main tuner 103 can then inform the background tuner 104 about same, such that the background tuner 104 can provide its diversity functionality.

Upon the time interval T having elapsed at time T2, the background tuner 104 is again tuned to the radio broadcast channel signal 302 for receiving the next RDS-TMC data block 304. After having received data block 304, the switching means 105 tune the background tuner 104 back to the receiving frequency of the radio broadcast channel signal 301 such that the background tuner 104 may continue to scan the frequency band at the alternative reception frequencies f1, f2, f3, f4, f5 of the radio broadcast channel signal 301. As the time interval T between TMC data block may vary, it is possible that the beginning of a TMC data block in the radio broadcast channel signal 302 providing the traffic and travel information has been missed, such that the data block cannot be decoded successfully. This situation and the operation of the radio broadcast receiver 101 according to the present invention is illustrated by Fig. 4.

Fig. 4 shows the radio broadcast channels signal 301 and signal 302 of Fig. 3 as well as several TMC data block 403, 404 and 405 in the radio broadcast channel signal 302 providing the TTI information. The expected time interval T between two successive TMC data blocks is also illustrated.

The TMC data block 404 has been transmitted earlier than expected by the radio broadcast receiver 101. At time T2, at which the background tuner 104 is tuned to the receiving frequency of radio broadcast channel signal 302, the beginning of the TMC data block 404 has been missed, such that this data block 404 cannot be decoded successfully. As the background tuner 104 will not find the beginning of a TMC data block in the corresponding time interval T between T2 and T4, the background tuner 104 would remained tuned to the radio broadcast channel signal 302 until time T5 at which the next TMC data block 404 has been received.

Hence, in between the time period T3 to T4, the background tuner 104 would not be able to receive the RDS data stream delivered in the radio broadcast channel signal 301, providing the user-selected program. As such an operation is undesirable, the timing means 108 also determines a predetermined time interval T_{back-otf}. Upon the predetermined time interval T_{back-off} elapsing, the switching means 105 tune the background tuner 104 to the receiving frequency of radio broadcast channel signal 301 independently of whether a TMC data block has been received in the radio broadcast channel signal 302 providing the TTI information. Applying the teaching provided by the present invention, it can be prevented that the background tuner 104 remains tuned to the radio broadcast channel signal 301 in case the beginning of a TMC data block has been missed or in case no TMC data block has been sent in the determined time interval T and the diversity functionality of background tuner 104 can be maintained.

In the timing means 108 a timer is measuring the elapsed time since the reception of a TMC data block and switches the background tuner 104 to the TMC radio broadcast channel signal 302. The background tuner 104 stays tuned to the TMC radio broadcast channel signal 302 until the expected TMC data block has been received. Additionally, a time-out in the form of a predetermined time interval T_{back-off} can be implemented after which the background tuner 104 switches back to the radio broadcast channel signal 301 selected by the user to continue scanning and to receive RDS information of that channel to prevent undesirable operation as described above. The duration of this predetermined time interval T_{back-off} is determined by maintaining a statistic of the measured time span between two successive TMC data blocks. This statistic is updated when the switching means 105 in the background tuner 104 switches from the radio broadcast program signal 301 selected by the listener to the TMC radio broadcast channel signal 302.

The time interval T between two TMC data blocks may be influenced by the reception quality of the TMC radio broadcast channel signal 302. The periodic switching between the radio broadcast channel signal 301 providing the user-selected program and the TMC radio broadcast channel signal 302 in the background tuner 104 can be adapted accordingly . In case of a poor reception quality it is usually difficult to successfully receive RDS data and, therefore, TMC data blocks can hardly be decoded. In these cases, the predetermined time interval T_{back-off} is shortened accordingly or, alternatively, a new initialisation has to be performed in case interferences during reception occur over a longer time period.

## Claims

1. A method for receiving digital data in a broadcast receiver including a main tuner and a background tuner, comprising the steps of:
tuning the main tuner to a first receiving frequency to receive a first broadcast channel signal,
tuning the background tuner to a second receiving frequency to receive a second broadcast channel signal, said second broadcast channel signal comprising digital information in data blocks,
receiving a first data block in the second broadcast channel signal at the background tuner and
tuning the background tuner to a third receiving frequency upon completing reception of the first data block,
**characterized by** further comprising the steps of:
maintaining a statistic on the deviation of the time interval between data blocks in the second broadcast channel signal,
estimating the time for transmission of the second data block in the second broadcast channel signal based on the maintained statistic, and
tuning the background tuner to said second receiving frequency at the estimated time of transmission of the second data block.

2. The method according to claim 1, further comprising the step of updating the statistic each time the background tuner changes the tuning from the third receiving frequency to the second receiving frequency.

3. The method according to claim 1 or 2, further comprising the step of varying the predetermined time interval based in the statistic.

4. The method according to one of claims 1 to 3, further comprising the step of tuning the background tuner to the at least third receiving frequency in case a predetermined time interval has elapsed without receiving a data block in the second radio broadcast channel signal.

5. The method according to one of claims 1 to 4, wherein the radio broadcast signals received at the first and at least one third receiving frequency provide the same radio broadcast program.

6. The method according to claim 5, wherein the third frequency is used in a scanning operation of the frequency band to determine an optimized receiving frequency of the radio broadcast program among alternative reception frequencies at the background tuner in a time span between the end of the reception of the first data block in the second broadcast channel signal and the estimated point in time of the transmission of the second data block.

7. The method according to claim 6. further comprising the step of receiving digital information in the third radio broadcast channel signal at the background tuner to determine the alternative receiving frequencies for the radio broadcast program.

8. The method according to claim 1 to 7, further comprising the step of reproducing the digital information in the second and/or third radio broadcast channel signal in an audio and/or visible format.

9. The method according to one of claims 1 to 8, further comprising the step of supplying the digital information in the second radio broadcast channel signal to a navigation system.

10. The method according to claim 9, further comprising the step of selecting the second receiving frequency based on travel route information provided by a navigation system.

11. The method according to one of claims 1 to 10, comprising the steps of measuring the reception quality of the second and/or third broadcast channel signal and
reducing the predetermined time interval in case the measured reception quality drops below a predetermined threshold.

12. The method according to one of claims 1 to 11, wherein the digital information in the second broadcast channel signal is traffic and travel information (TTI).

13. The method according to claim 12, wherein the traffic and travel information (TTI) is encoded in the traffic message channel (TMC) format.

14. The method according to one of claims 1 to 13, wherein the digital information in the third radio broadcast channel signal is traffic and travel information (TTI) or radio data system (RDS) information.

15. The method according to one of claims 1 to 14, wherein the step of receiving the second broadcast channel signal comprises outputting the audio signals received.

16. A broadcast receiver for receiving digital information in broadcast channel signals, comprising:
a main tuner (103) adapted to receive a first broadcast channel signal (301) at a first receiving frequency,
a background tuner (104) adapted to receive a second broadcast channel signal (302) at a second receiving frequency and adapted to receive a third broadcast channel signal at a third receiving frequency, said second radio broadcast signal (302) comprising digital data (303), said digital data being transmitted as discrete data blocks, and
wherein the background tuner (104) comprises switching means (105) adapted to switch the background tuner (104) to the second receiving frequency for receiving a first data block (303), and adapted to switch the background tuner (104) to at least one third receiving frequency after completion of the reception of the first data block (303),
**characterized by** further comprising:
means for maintaining a statistic on the deviation of the time interval between data blocks in the second broadcast channel signal
timing means (108) adapted to estimate the time of transmission of the next data block (304) in said second radio broadcast channel signal (302) based on said statistic, and in that the switching means of the background tuner (104) is adapted to switch the background tuner back to said second receiving frequency for receiving a second data block (304) at the time estimated by the timing means.

17. The broadcast receiver according to claim 16, wherein the switching means (105) are adapted to switch the background tuner (104) to the at least third receiving frequency in case a predetermined time interval (T_{back-off}) has elapsed without receiving a data block (404) in the second radio broadcast channel signal (302).

18. The broadcast receiver according to claim 16 or 17, wherein the broadcast signals received at the first and third receiving frequency provide the same radio broadcast program.

19. The broadcast receiver according to one of claims 16 to 18, further comprising a display (112) for displaying information derived from the data blocks in the second and/or third radio broadcast channel signal (301, 302).

20. The broadcast receiver according to one of claims 16 to 19, wherein information derived from the data blocks in the second and/or third radio broadcast channel signal (301, 302) is output by a speaker (113) in an audio format.

21. The broadcast receiver according to one of claims 18 to 20, wherein the background tuner (104) comprises frequency selection means
for scanning the frequency band for an optimized receiving frequency of the radio broadcast program among a plurality of possible frequencies in a time span between the completion of the reception of first data block (303) in the second radio broadcast channel signal (302) and the point in time estimated by the timing means (108) and
for tuning the main tuner (101) to the optimized receiving frequency providing the best reception quality.

22. The broadcast receiver according to one of claims 16 to 21, the broadcast receiver (101) being connected to a navigation system (110), wherein the radio broadcast receiver (101) is adapted to supply the digital information in the second radio broadcast channel signal (302) or information derived therefrom to the navigation system (110).

23. The radio broadcast receiver according to claim 22, wherein the background tuner (104) is adapted to select the second receiving frequency based on travel route information provided by the navigation system (110).

24. The radio broadcast receiver according to one of claims 16 to 23, wherein the digital information (303, 304, 305) in the second radio broadcast channel signal (302) comprises traffic and travel information.

25. The broadcast receiver according to one of claims 18 to 24, further comprising reception quality measurement means (109) for measuring the reception quality of the second and/or third radio broadcast channel signal (301,302).

26. The broadcast receiver according to claim 25, wherein the timing means (108) are adapted to estimate the time (T) for receiving a further data block and the predetermined time interval (T_{back-off}) based on the measured reception quality.

27. The broadcast receiver according to claim 25, wherein the digital information is transmitted in the traffic message channel format.

28. The broadcast receiver according to one of claims 20 to 26, wherein the digital information in the third radio broadcast channel signal (301) is traffic and travel information and/or radio data system information.

29. The broadcast receiver according to one of claims 16 to 28, further comprising a speaker (113) for outputting the received audio signals.

30. An in-vehicle receiver comprising a radio broadcast receiver (101) according to one of claims 16 to 29.

## Patentansprüche

1. Verfahren zum Empfangen digitaler Daten in einem Rundfunkempfänger, der einen Haupt-Tuner und einen Hintergrund-Tuner enthält, wobei das Verfahren die folgenden Schritte umfasst:
Abstimmen des Haupt-Tuners auf eine erste Empfangsfrequenz, um ein erstes RundfunkSignal zu empfangen,
Abstimmen des Hintergrund-Tuners auf eine zweite Empfangsfrequenz, um ein zweites Rundfunkkanal-Signal zu empfangen, wobei das zweite Rundfunkkanal-Signal digitale Informationen in Datenblöcken umfasst,
Empfangen eines ersten Datenblocks in dem zweiten Rundfunkkanal-Signal an dem Hintergrund-Tuner, und
Abstimmen des Hintergrund-Tuners auf eine dritte Empfangsfrequenz nach Abschluss von Empfang des ersten Datenblocks,
**dadurch gekennzeichnet, dass** das Verfahren des Weiteren die folgenden Schritte umfasst:
Führen einer Statistik über die Abweichung des Zeitintervalls zwischen Datenblöcken in dem zweiten Rundfunkkanal-Signal,
Schätzen der Zeit zum Senden des zweiten Datenblocks in dem zweiten Rundfunkkanal-Signal auf Basis der geführten Statistik, und
Abstimmen des Hintergrund-Tuners auf die zweite Empfangsfrequenz zu der geschätzten Sendezeit des zweiten Datenblocks.

2. Verfahren nach Anspruch 1, das des Weiteren den Schritt umfasst, in dem die Statistik immer dann aktualisiert wird, wenn der Hintergrund-Tuner die Abstimmung von der dritten Empfangsfrequenz auf die zweite Empfangsfrequenz ändert.

3. Verfahren nach Anspruch 1 oder 2, das des Weiteren den Schritt umfasst, in dem das vorgegebene Zeitintervall auf Basis der Statistik variiert wird.

4. Verfahren nach einem der Ansprüche 1 bis 3, das des Weiteren den Schritt umfasst, in dem der Hintergrund-Tuner auf wenigstens die dritte Empfangsfrequenz abgestimmt wird, wenn ein vorgegebenes Zeitintervall verstrichen ist, ohne dass ein Datenblock in dem zweiten Radio-Rundfunkkanal-Signal empfangen worden ist.

5. Verfahren nach einem der Ansprüche 1 bis 4, wobei die auf der ersten und wenigstens einen dritten Empfangsfrequenz empfangenen Radio-Rundfunksignale das gleiche Radio-Rundfunkprogramm bereitstellen.

6. Verfahren nach Anspruch 5, wobei die dritte Frequenz in einem Vorgang des Scannens des Frequenzbandes verwendet wird, um eine optimierte Empfangsfrequenz des Radio-Rundfunkprogramms unter alternativen Empfangsfrequenzen an dem Hintergrund-Tuner in einer Zeitspanne zwischen dem Ende des Empfangs des ersten Datenblocks in dem zweiten Rundfunkkanal-Signal und dem geschätzten Sendezeitpunkt des zweiten Datenblocks zu bestimmen.

7. Verfahren nach Anspruch 6, das des Weiteren den Schritt umfasst, in dem digitale Informationen in dem dritten Radio-Rundfunkkanal-Signal an dem Hintergrund-Tuner empfangen werden, um die alternativen Empfangsfrequenzen für das Radio-Rundfunkprogramm zu bestimmen.

8. Verfahren nach Anspruch 1 bis 7, das des Weiteren den Schritt des Reproduzierens der digitalen Informationen in dem zweiten und/oder dritten Radio-Rundfunkkanal-Signal in einem Ton- und/oder Bildformat umfasst.

9. Verfahren nach einem der Ansprüche 1 bis 8, das des Weiteren den Schritt des Zuführens der digitalen Informationen in dem zweiten Radio-Rundfunkkanal-Signal zu einem Navigationssystem umfasst.

10. Verfahren nach Anspruch 9, das des Weiteren den Schritt umfasst, in dem die zweite Empfangsfrequenz auf Basis durch ein Navigationssystem bereitgestellter Reiserouten-Informationen ausgewählt wird.

11. Verfahren nach einem der Ansprüche 1 bis 10, das die Schritte umfasst, in denen die Empfangsqualität des zweiten und/oder dritten Rundfunkkanal-Signals gemessen wird, und das vorgegebene Zeitintervalls verkürzt wird, wenn die gemessene Empfangsqualität unter einen vorgegebenen Schwellenwert fällt.

12. Verfahren nach einem der Ansprüche 1 bis 11, wobei die digitalen Informationen in dem zweiten Rundfunkkanal-Signal Verkehrs- und Reiseinformationen sind.

13. Verfahren nach Anspruch 12, wobei die Verkehrs- und Reiseinformationen in dem TMC-Format (traffic message channel format) kodiert sind.

14. Verfahren nach einem der Ansprüche 1 bis 13, wobei die digitalen Informationen in dem dritten Radio-Rundfunkkanal-Signal Verkehrs- und Reiseinformationen oder RDS-Informationen (radio data system information) sind.

15. Verfahren nach einem der Ansprüche 1 bis 14, wobei der Schritt des Empfangens des zweiten Rundfunkkanal-Signals Ausgeben der empfangenen Audiosignale umfasst.

16. Rundfunkempfänger zum Empfangen digitaler Informationen in Rundfunkkanal-Signalen, der umfasst:
einen Haupt-Tuner (103), der zum Empfangen eines ersten Rundfunkkanal-Signals (301) auf einer ersten Empfangsfrequenz eingerichtet ist,
einen Hintergrund-Tuner (104), der zum Empfangen eines zweiten Rundfunkkanal-Signals (302) auf einer zweiten Empfangsfrequenz eingerichtet ist und zum Empfangen eines dritten Rundfunkkanal-Signals auf einer dritten Empfangsfrequenz eingerichtet ist, wobei das zweite Radio-Rundfunksignal (302) digitale Daten (303) umfasst und die digitalen Daten als diskrete Datenblöcke gesendet werden, und
der Hintergrund-Tuner (104) eine Schalteinrichtung (105) umfasst, die so eingerichtet ist, dass sie den Hintergrund-Tuner (104) auf die zweite Empfangsfrequenz schaltet, um einen ersten Datenblock (303) zu empfangen, und so eingerichtet ist, dass sie den Hintergrund-Tuner (104) nach Abschluss von Empfang des ersten Datenblocks (303) auf wenigstens eine dritte Empfangsfrequenz schaltet,
**dadurch gekennzeichnet, dass** er des Weiteren umfasst:
eine Einrichtung zum Führen einer Statistik über die Abweichung des Zeitintervalls zwischen Datenblöcken in dem zweiten Rundfunkkanal-Signal,
eine Zeitsteuereinrichtung (108), die so eingerichtet ist, dass sie die Sendezeit des nächsten Datenblocks (304) in dem zweiten Radio-Rundfunkkanal-Signal (302) auf Basis der Statistik schätzt, und
dadurch, dass die Schalteinrichtung des Hintergrund-Tuners so eingerichtet ist, dass sie den Hintergrund-Tuner wieder auf die zweite Empfangsfrequenz schaltet, um einen zweiten Datenblock (304) zu der durch die Zeitsteuereinrichtung geschätzten Zeit zum Empfangen zu empfangen.

17. Rundfunkempfänger nach Anspruch 16, wobei die Schalteinrichtung (105) so eingerichtet ist, dass sie den Hintergrund-Tuner (104) wenigstens auf die dritte Empfangsfrequenz schaltet, wenn ein vorgegebenes Zeitintervall (T_{back-off}) ohne Empfang eines Datenblocks (404) in dem zweiten Radio-Rundfunkkanal-Signal (302) verstrichen ist.

18. Rundfunkempfänger nach Anspruch 16 oder 17, wobei die auf der ersten und der dritten Empfangsfrequenz empfangenen Rundfunkssignale das gleiche Radio-Rundfunkprogramm bereitstellen.

19. Rundfunkempfänger nach einem der Ansprüche 16 bis 18, der des Weiteren eine Anzeigeeinrichtung (112) zum Anzeigen von Informationen umfasst, die aus den Datenblöcken in dem zweiten und/oder dritten Radio-Rundfunkkanal-Signal (301, 302) hergeleitet werden.

20. Rundfunkempfänger nach einem der Ansprüche 16 bis 19, wobei die aus den Datenblöcken in dem zweiten und/oder dritten Radio-Rundfunkkanal-Signal (301, 302) hergeleiteten Informationen von einem Lautsprecher (113) in einem Tonformat ausgegeben werden.

21. Rundfunkempfänger nach einem der Ansprüche 18 bis 20, wobei der Hintergrund-Tuner (104) eine Frequenzwähleinrichtung umfasst, mit der
das Frequenzband auf eine optimierte Empfangsfrequenz des Radio-Rundfunkprogramms unter einer Vielzahl möglicher Frequenzen in einer Zeitspanne zwischen dem Abschluss des Empfangs des ersten Datenblocks (303) in dem zweiten Radio-Rundfunkkanal-Signal (302) und dem durch die Zeitsteuereinrichtung (108) geschätzten Zeitpunkt gescannt wird, und
der Haupt-Tuner (101) auf die optimierte Empfangsfrequenz abgestimmt wird, die die beste Empfangsqualität bereitstellt.

22. Rundfunkempfänger nach einem der Ansprüche 16 bis 21, wobei der Rundfunkempfänger (101) mit einem Navigationssystem (110) verbunden ist und der Radio-Rundfunkempfänger (101) so eingerichtet ist, dass er die digitalen Informationen in dem zweiten Radio-Rundfunkkanal-Signal (302) oder daraus hergeleitete Informationen dem Navigationssystem (110) bereitstellt.

23. Radio-Rundfunk-Empfänger nach Anspruch 22, wobei der Hintergrund-Tuner (104) so eingerichtet ist, dass er die zweite Empfangsfrequenz auf Basis durch das Navigationssystem (110) bereitgestellter Reiserouten-Informationen auswählt.

24. Radio-Rundfunk-Empfänger nach einem der Ansprüche 16 bis 23, wobei die digitalen Informationen (303, 304, 305, 310) in dem zweiten Radio-Rundfunkkanal-Signal (302) Verkehrs- und Reiseninformationen umfassen.

25. Rundfunkempfänger nach einem der Ansprüche 18 bis 24, der des Weiteren eine Empfangsqualitäts-Messeinrichtung (109) zum Messen der Empfangsqualität des zweiten und/oder dritten Radio-Rundfunkkanal-Signals (301, 302) umfasst.

26. Rundfunkempfänger nach Anspruch 25, wobei die Zeitsteuereinrichtung (108) so eingerichtet ist, dass sie die Zeit (T) zum Empfangen eines zweiten Datenblocks und das vorgegebene Zeitintervall (T_{back-off}) auf Basis der gemessenen Empfangsqualität schätzt.

27. Rundfunkempfänger nach Anspruch 25, wobei die digitalen Informationen in dem TMC-Format (traffic message channel format) gesendet werden.

28. Rundfunkempfänger nach einem der Anspruch 20 bis 26, wobei die digitalen Informationen in dem dritten Radio-Rundfunkkanal-Signal (301) Verkehrs- und Reiseinformationen und/oder RDS-Informationen (radio data system information) sind.

29. Rundfunkempfänger nach einem der Ansprüche 16 bis 28, der des Weiteren einen Lautsprecher (113) zum Ausgeben der empfangenen Audiosignale umfasst.

30. Fahrzeugempfänger, der einen Radio-Rundfunkempfänger (101) nach einem der Ansprüche 16 bis 29 umfasst.

## Revendications

1. Procédé pour recevoir des données numériques dans un récepteur de diffusion comprenant un syntoniseur principal et un syntoniseur d'arrière-plan, comprenant les étapes consistant à :
syntoniser le syntoniseur principal à une première fréquence de réception pour recevoir un premier signal de canal de diffusion,
syntoniser le syntoniseur d'arrière-plan à une deuxième fréquence de réception pour recevoir un deuxième signal de canal de diffusion, ledit deuxième signal de canal de diffusion comprenant de l'information numérique en blocs de données,
recevoir un premier bloc de données dans le deuxième signal de canal de diffusion au syntoniseur d'arrière-plan, et
syntoniser le syntoniseur d'arrière-plan à une troisième fréquence de réception après réception du premier bloc de données,
**caractérisé en ce qu'**il comprend en outre les étapes consistant à :
tenir des statistiques sur la déviation de l'intervalle temporel entre des blocs de données dans le deuxième signal de canal de diffusion,
estimer le temps de transmission du deuxième bloc de données dans le deuxième signal de canal de diffusion sur la base des statistiques tenues, et
syntoniser le syntoniseur d'arrière-plan à ladite deuxième fréquence de réception au temps de transmission estimé du deuxième bloc de données.

2. Procédé selon la revendication 1, comprenant en outre l'étape de mise à jour des statistiques chaque fois que le syntoniseur d'arrière-plan change la syntonisation de la troisième fréquence de réception à la deuxième fréquence de réception.

3. Procédé selon la revendication 1 ou 2, comprenant en outre l'étape de variation de l'intervalle de temps prédéterminé sur la base des statistiques.

4. Procédé selon l'une des revendications 1 à 3, comprenant en outre l'étape de syntonisation du syntoniseur d'arrière-plan à l'au moins troisième fréquence de réception si un intervalle de temps prédéterminé s'est écoulé sans recevoir un bloc de données dans le deuxième signal de canal de radiodiffusion.

5. Procédé selon l'une des revendications 1 à 4, dans lequel les signaux de radiodiffusion reçus à la première et à au moins une troisième fréquence de réception procurent le même programme de radiodiffusion.

6. Procédé selon la revendication 5, dans lequel la troisième fréquence est utilisée dans une opération de balayage de la bande de fréquence pour déterminer une fréquence de réception optimisée du programme de radiodiffusion parmi des fréquences de réception alternatives au syntoniseur d'arrière-plan dans un intervalle temporel entre la fin de la réception du premier bloc de données dans le deuxième signal de canal de diffusion et le moment estimé de la transmission du deuxième bloc de données.

7. Procédé selon la revendication 6, comprenant en outre l'étape de réception d'information numérique dans le troisième signal de canal de radiodiffusion au syntoniseur d'arrière-plan pour déterminer les fréquences de réception alternatives pour le programme de radiodiffusion.

8. Procédé selon l'une des revendications 1 à 7, comprenant en outre l'étape de reproduction de l'information numérique dans le deuxième et/ou troisième signal de canal de radiodiffusion sous un format audible et/ou visible.

9. Procédé selon l'une des revendications 1 à 8, comprenant en outre l'étape de provision de l'information numérique dans le deuxième signal de canal de radiodiffusion à un système de navigation.

10. Procédé selon la revendication 9, comprenant en outre l'étape de sélection de la deuxième fréquence de réception sur base d'information d'itinéraire procurée par un système de navigation.

11. Procédé selon l'une des revendications 1 à 10, comprenant les étapes consistant à :
mesurer la qualité de réception du deuxième et/ou du troisième signal de canal de diffusion, et
réduire l'intervalle de temps prédéterminé si la qualité de réception mesurée chute sous un seuil prédéterminé.

12. Procédé selon l'une des revendications 1 à 11, dans lequel l'information numérique dans le deuxième signal de canal de diffusion est de l'information de trafic et d'itinéraire, soit Traffic and Travel Information (TTI).

13. Procédé selon la revendication 12, dans lequel l'information de trafic et d'itinéraire (TTI) est codée sous le format de canal de message de trafic, soit Traffic Message Channel (TMC).

14. Procédé selon l'une des revendications 1 à 13, dans lequel l'information numérique dans le troisième signal de canal de radiodiffusion est de l'information de trafic et d'itinéraire (TTI) ou de l'information de système de radiocommunication de type Radio Data System (RDS).

15. Procédé selon l'une des revendications 1 à 14, dans lequel l'étape de réception du deuxième signal de canal de diffusion comprend la sortie des signaux audio reçus.

16. Récepteur de diffusion pour recevoir de l'information numérique dans des signaux de canal de diffusion, comprenant :
un syntoniseur principal (103) adapté pour recevoir un premier signal de canal de diffusion (301) à une première fréquence de réception,
un syntoniseur d'arrière-plan (104) adapté pour recevoir un deuxième signal de canal de diffusion (302) à une deuxième fréquence de réception et adapté pour recevoir un troisième signal de canal de diffusion à une troisième fréquence de réception, ledit deuxième signal de radiodiffusion (302) comprenant des données numériques (303), lesdites données numériques étant transmises par blocs de données discrets, et
dans lequel le syntoniseur d'arrière-plan (104) comprend un moyen de commutation (105) adapté pour commuter le syntoniseur d'arrière-plan (104) à la deuxième fréquence de réception pour recevoir un premier bloc de données (303), et adapté pour commuter le syntoniseur d'arrière-plan (104) à au moins une troisième fréquence de réception après réception du premier bloc de données (303),
**caractérisé en ce qu'**il comprend en outre :
un moyen pour tenir des statistiques de la déviation de l'intervalle temporel entre des blocs de données dans le deuxième signal de canal de diffusion,
un moyen de synchronisation (108) adapté pour estimer le temps de transmission du bloc de données suivant (304) dans ledit deuxième signal de canal de radiodiffusion (302) sur la base des desdites statistiques, et
**en ce que** le moyen de commutation du syntoniseur d'arrière-plan (104) est adapté pour recommuter le syntoniseur d'arrière-plan à ladite deuxième fréquence de réception pour recevoir un deuxième bloc de données (304) au moment estimé par le moyen de synchronisation.

17. Récepteur de diffusion selon la revendication 16, dans lequel les moyens de commutation (105) sont adaptés pour commuter le syntoniseur d'arrière-plan (104) à au moins la troisième fréquence de réception si un intervalle de temps prédéterminé (T_{back-off}) s'est écoulé sans recevoir un bloc de données (404) dans le deuxième signal de canal de radiodiffusion (302).

18. Récepteur de diffusion selon la revendication 16 ou 17, dans lequel les signaux de diffusion reçus à la première et à la troisième fréquence de réception procurent le même programme de radiodiffusion.

19. Récepteur de diffusion selon l'une des revendications 16 à 18, comprenant en outre un affichage (112) pour afficher de l'information dérivée des blocs de données dans les deuxième et/ou troisième signaux de canal de radiodiffusion (301, 302).

20. Récepteur de diffusion selon l'une des revendications 16 à 19, dans lequel de l'information dérivée des blocs de données dans les deuxième et/ou troisième signaux de canal de radiodiffusion (301, 302) est sortie par un haut-parleur (113) sous un format audio.

21. Récepteur de diffusion selon l'une des revendications 18 à 20, dans lequel le syntoniseur d'arrière-plan (104) comprend un moyen de sélection de fréquence
pour balayer la bande de fréquence afin de déterminer une fréquence de réception optimisée du programme de radiodiffusion parmi une pluralité de fréquences possibles pendant une période comprise entre la fin de la réception du premier bloc de données (303) dans le deuxième signal de canal de radiodiffusion (302) et le moment estimé par le moyen de synchronisation (108), et
pour syntoniser le syntoniseur principal (101) à la fréquence de réception optimisée qui procure la meilleure qualité de réception.

22. Récepteur de diffusion selon l'une des revendications 16 à 21, le récepteur de diffusion (101) étant connecté à un système de navigation (110), dans lequel le récepteur de radiodiffusion (101) est adapté pour fournir l'information numérique dans le deuxième signal de canal de radiodiffusion (302), ou l'information qui en est dérivée, au système de navigation (110).

23. Récepteur de radiodiffusion selon la revendication 22, dans lequel le syntoniseur d'arrière-plan (104) est adapté pour sélectionner la deuxième fréquence de réception sur base d'information d'itinéraire procurée par le système de navigation (110).

24. Récepteur de radiodiffusion selon l'une des revendications 16 à 23, dans lequel l'information numérique (303, 304, 305) dans le deuxième signal de canal de radiodiffusion (302) comprend de l'information de trafic et d'itinéraire.

25. Récepteur de diffusion selon l'une des revendications 18 à 24, comprenant en outre un moyen de mesure de qualité de réception (109) pour mesurer la qualité de réception des deuxième et/ou troisième signaux de canal de radiodiffusion (301, 302).

26. Récepteur de diffusion selon la revendication 25, dans lequel les moyens de synchronisation (108) sont adaptés pour estimer le temps (T) de réception d'un autre bloc de données et l'intervalle temporel prédéterminé (T_{back-off}) à partir de la qualité de réception mesurée.

27. Récepteur de diffusion selon la revendication 25, dans lequel l'information numérique est transmise sous le format de canal de message de trafic.

28. Récepteur de diffusion selon l'une des revendications 20 à 26, dans lequel l'information numérique dans le troisième signal de canal de radiodiffusion (301) est de l'information de trafic et d'itinéraire (TTI) et/ou de l'information de système de radiocommunication RDS.

29. Récepteur de diffusion selon l'une des revendications 16 à 28, comprenant en outre un haut-parleur (113) pour sortir les signaux audio reçus.

30. Récepteur monté à bord d'un véhicule, comprenant un récepteur de radiodiffusion (101) selon l'une des revendications 16 à 29.
